# EUROPÄISCHE PATENTSCHRIFT

(11) **EP 1 617 485 B1**
(45) Veröffentlichungstag und Bekanntmachung des Hinweises auf die Patenterteilung: **06.06.2007**
(21) Anmeldenummer: 04016311.5
(22) Anmeldetag: 12.07.2004
(51) Int. Cl.: H01L 31/02, F24J 2/46, F24J 2/52

(54) **Modulares Stecksystem zur sicheren Lagerung von horizontal gestapelten Photovoltaik-Modulen beim Transport**
Modular assembling system for the safe storage of horizontally stacked photovoltaic modules during transport
Système modulaire d'assemblage pour le stockage sûr de modules photovoltaiques empilés horizontalement pendant le transport

(43) Veröffentlichungstag der Anmeldung: 18.01.2006
(73) Patentinhaber: Häberlein-Lehr, Ulla, 64319 Pfungstadt (DE)
(72) Erfinder: Häberlein, Joachim, 64319 Pfungstadt (DE)
(74) Vertreter: Quermann, Helmut

(56) Entgegenhaltungen:
- EP-A- 0 545 563
- US-A- 4 131 111
- US-A- 5 014 163
- US-A- 5 677 830
- US-B1- 6 543 724
- PATENT ABSTRACTS OF JAPAN Bd. 2000, Nr. 06, 22. September 2000 (2000-09-22) -& JP 2000 079961 A (MISAWA HOMES CO LTD), 21. März 2000 (2000-03-21)
- PATENT ABSTRACTS OF JAPAN Bd. 2000, Nr. 19, 5. Juni 2001 (2001-06-05) -& JP 2001 031215 A (MITSUBISHI HEAVY IND LTD), 6. Februar 2001 (2001-02-06)

## Beschreibung

Die Erfindung betrifft ein modulares Stecksystem zur sicheren Lagerung von horizontal gestapelten Photovoltaik-Modulen beim Transport.

Dank einem gewandelten Energiebewusstsein der Bevölkerung und unterstützt durch staatliche Förderinitiativen hat die Nutzung erneuerbarer Energiequellen immer mehr wirtschaftliche Bedeutung gewonnen - dies gilt vor allem auch für den Bereich der Photovoltaik, der Umwandlung von Sonnenlicht in Strom.

Vielerorts - nicht nur in Deutschland - sind leistungsfähige, hochmodern ausgestatte Fabriken entstanden, in denen heute Photovoltaik-Module nach rationellsten Verfahren als Massenartikel hergestellt werden, um in alle Teile Europas und der Welt versandt zu werden.

Überlegungen zur innovativen Rationalisierung dürfen sich nicht nur auf fertigungstechnische Kriterien beschränken, sondern müssen auch den Bereich Versand bzw. Verpackung und Transportsicherung erfassen.

Photovoltaische Module (PV-Module) bestehen in der Standard-Ausführung aus:
- einer vorderseitigen - meist 4 mm dicken - Einscheiben-Sicherheitsglasscheibe,
- zwei verschmolzenen Lagen transparenter Laminierfolie, zwischen welche die Photovoltaik-Zellen - meist aus Silicium - sowie ein elektrisches Leitersystem eingebettet sind
- sowie einer die Rückseite dampfdiffusionsdicht verschließenden speziellen Kunststoff-Folie. Man spricht in diesem Fall von Glas/Kunststoff-Modulen. Die Rückseite kann statt dessen aber auch mit einer Glasscheibe versehen sein (Glas/Glas-Module).

In den meisten Fällen sind Standard-PV-Module mit einem Rahmen aus gezogenem Aluminiumprofil ausgestattet, zum Beispiel mit einer Rahmentiefe von 42 mm.
In selteneren Fällen werden aber auch rahmenlose PV-Module - sowohl in der Ausführung als Glas/Kunststoff-Module wie auch als Glas/Glas-Module - versandt.

Die Größe von PV-Standardmodulen liegt meist im Bereich zwischen 0,8 und 1,6 qm. Das Gewicht liegt bei gerahmten Modulen meist im Bereich zwischen 14 und 28 kg. Glas-Glas-Module sind um rund 60 % schwerer.

Für den Transport zum Kunden werden die PV-Module üblicherweise einzeln in Kartonage verpackt und auf Holzpaletten horizontal gestapelt. Um den Stapel aus Einzelpackungen gegen Verrutschung zu sichern, wird er durch Spannbänder mit der Palette verbunden.

Die hier beschriebene allgemein übliche Methode der Transportverpackung von PV-Modulen ist mit gravierenden Nachteilen verbunden:
Zum einen kann hierbei nur bis zu einer begrenzten Stapelhöhe gestapelt werden. Denn die sich addierende Gewichtslast der gestapelten Module überträgt sich auf die zuunterst liegenden Module.

Zur statischen Belastung kommt die dynamische Belastung beim Transport - zum Beispiel durch hartes Absetzen mit dem Gabelstapler, Beschleunigungs-, Verzögerungs- und Zentrifugalkräfte beim LKW-Transport und vor allem Erschütterungen beim Fahren über Schwellen und Schlaglöcher. All dies kann bei zu hoher Stapelung leicht zur Beschädigung des oder der zuunterst liegenden Moduls bzw. Module führen.

Verpackte PV-Module werden deshalb selten in Stapelhöhen von mehr als 1 m transportiert.
Wegen der Gefahr der Überbelastung unten liegender Module ist auch ist die Übereinanderstapelung von 2 beladenen Paletten unmöglich. Dies hat zur Folge, dass die Ladehöhe eines LKW-Laderaums häufig nur teilweise genutzt werden kann.

Zum anderen verursacht das Auspacken der einzeln kartonierten Module beim Endabnehmer einen nicht unerheblichen Arbeitsaufwand. Hinzu kommt schliesslich die undankbare Aufgabe, beträchtliche Mengen Kartonage am Montageort zu sammeln, erforderlichenfalls zu zerkleinern und dem Papierrecycling zuzuführen.

Aus Patent Abstracts of Japan Bd. 2000, Nr. 06, 22. September 2000 - & JP 2000 079961 A (Misawa Homes Co. Ltd.), 21. März 2000 ist ein modulares Stecksystem zur sicheren Lagerung von horizontal gestapelten Photovoltaik-Modulen bekannt. Das System ist als Rahmenkonstruktion gestaltet, die durch vier vertikal verlaufende Säulen und diese verbindende horizontale Streben gebildet ist. Mehrere Rahmeneinheiten der Rahmenkonstruktion sind übereinander stapelbar und mittels einer Steckverbindung verbunden. Jede Rahmeneinheit weist vier Säulenabschnitte und diese verbindende horizontale Streben auf. Zum Zusammenstecken übereinander angeordneter Säulenabschnitte weist die jeweilige Säule oben einen Zapfen und unten eine Ausnehmung auf. Die Photovoltaik-Module sind in zwei der vier horizontalen Streben, und zwar in zwei parallel zueinander angeordneten Streben der jeweiligen Rahmeneinheit gelagert. Hierzu nehmen die beiden Streben Verschiebeteile auf, auf denen das Modul ruht. Der jeweilige Säulenabschnitt der Säule ist als glatter Stab mit den geformten Enden gestaltet.

Aus den hier dargelegten Betrachtungen ergab sich die erfinderische Aufgabe, ein Verpackungs- bzw. Transportsicherungssystem für PV-Module zu schaffen, welches:
- auch bei hohen Stapelhöhen einen sicheren Transport gewährleistet und die Gefahr einer Beschädigung der zuunterst liegenden Module ausschließt,
- eine Einzelverpackung der Module mit Kartonage überflüssig macht und den Verpackungsaufwand insgesamt auf das notwendige Minimum reduziert und
- aus kostengünstig herstellbaren, möglichst einheitlich geformten und möglichst kleinteiligen, sehr stabilen Einzelelementen besteht, die an den Modulhersteller zurückgesandt und in einer hohen Zahl von Umläufen wieder verwendet werden können.

Zur Lösung dieser Aufgabe schlägt die Erfindung ein modulares Stecksystem zur sicheren Lagerung von horizontal gestapelten Photovoltaik-Modulen beim Transport vor, wobei das System ausschließlich aus einzelnen vertikal angeordneten, lastabtragenden Säulen gebildet ist, die jeweils aus Formteil-Gliedem bestehen, die übereinander angeordnet und ineinander gesteckt die jeweilige Säule bilden, wobei jedes dieser Formteil-Glieder, auf der Seite, die zu dem zu tragenden Photovoltaik-Modul hin gerichtet ist, mit einem Last aufnehmenden Tragprofil als Auflagevorrichtung für das Photovoltaik-Modul, oberseitig bzw. unterseitig mit einem oder mehreren Zapfen oder einer Feder und unterseitig bzw. oberseitig mit einem oder mehreren offenen Hohlräumen zur passgenauen Aufnahme der/des Zapfen (s) oder mit einer Nut zur Aufnahme der Feder ausgestattet ist. Aus ergonomischen Gründen ist das jeweilige Formteil-Glied oberseitig mit dem bzw. den Zapfen oder der Feder und unterseitig mit dem bzw. den nach unten offenen Hohlräumen oder der Nut ausgestattet.

Das Last aufnehmende Tragprofil kann das Photovoltaik-Modul an beliebigen Stellen tragen, beispielsweise im Bereich deren Seiten. Es wird aber als vorteilhaft angesehen, insbesondere vor dem Hintergrund von Photovoltaik-Modulen, die Rechteckform aufweisen, wenn die Last aufnehmenden Tragprofile als Auflagevorrichtung für jeweils eine der vier Ecken des rechteckigen Photovoltaik-Moduls dienen. Insbesondere ist sicherzustellen, dass die Tragprofile verrutschungssichere Auflagevorrichtungen für das Photovoltaik-Modul darstellen.

Es wird somit insbesondere ein System von vier lastabtragenden Säulen, insbesondere vier lastabtragende Ecksäulen vorgeschlagen. An den vier Ecken der zu stapelnden Module werden vier Säulen angeordnet, die die Aufgabe haben, die sich addierende Gewichtslast der PV-Module aufzunehmen und außerhalb der PV-Module auf eine tragende Palette abzuleiten.

Die vier Säulen weisen die modularen, einheitlich geformten Formteil-Glieder auf. Jedes dieser Glieder hat die Aufgabe, ein Viertel der Gewichtslast eines einzelnen PV-Moduls aufzunehmen und auf die Säule zu übertragen. Durch eine einfache mechanische Steckverbindung wird jedes Glied mit dem benachbarten Glied verbunden.

Die modularen Formteil-Glieder bilden somit, zusammengesteckt, eine hochbelastbare Tragsäule. Die verschiebungssichere Verbindung jedes Formteil-Gliedes mit dem benachbarten Glied wird über eine Steckmechanik erzielt, zum Beispiel über eine Zapfen-Hohlraum-Konstruktion. Jedes der Formteil-Glieder ist innenseitig mit dem Last aufnehmenden Tragprofil ausgestattet, in welches das PV-Modul, insbesondere im Bereich der jeweiligen Ecken, passgenau eingefügt wird. Auf das Tragprofil wirken nur relativ geringe Gewichts- und dynamische Lasten ein.

Gemäß einer vorteilhaften Gestaltung weisen die Formteil-Glieder eine rechtwinklig winkelförmige Form auf. Gemäß einer vorteilhaften, alternativen Gestaltung ist vorgesehen, dass die Formteil-Glieder zusammengesteckt eine runde Tragsäule bilden. Die Steckverbindung erfolgt jeweils über nur einen Zapfen und einen Hohlraum. Neben einer winkelförmigen oder runden Formgebung der Tragsäule sind ebenso dreieckige, viereckige oder mehreckige Formen möglich.

Weitere Merkmale der Erfindung sind in den Unteransprüchen, der nachfolgenden Beschreibung, die sich insbesondere auf die Beschreibung der Figuren bezieht, sowie den Figuren selbst dargestellt, wobei bemerkt wird, dass alle Einzelmerkmale und alle Kombinationen von Einzelmerkmalen weitere erfinderische Ausgestaltungen darstellen.

In den Figuren ist die Erfindung anhand mehrerer Ausführungsbeispiele erläutert, ohne hierauf beschränkt zu sein. Es zeigt:
- Figur 1: eine erste Ausführungsform eines Formteil-Gliedes, in einer räumlichen Ansicht, schräg von unten gesehen,
- Figur 2: das in Figur 1 gezeigte Formteil-Glied, in einer räumlichen Ansicht, schräg von oben gesehen,
- Figur 3: zwei aufeinander gesteckte Formteil-Glieder gemäß der Ausführungsform nach den Figuren 1 und 2, wobei das untere FormteilGlied ein nur im Eckbereich dargestelltes rechteckiges Photovoltaik-Modul im Bereich einer Ecke aufnimmt,
- Figur 4: einen Schnitt durch die Anordnung gemäß Figur 3,
- Figur 5: eine zweite Ausführungsform eines Formteil-Gliedes,
- Figur 6: eine Anordnung zweier Formteil-Glieder gemäß einer dritten Ausführungsform, und
- Figur 7: eine vierte Ausführungsform eines Formteil-Gliedes.

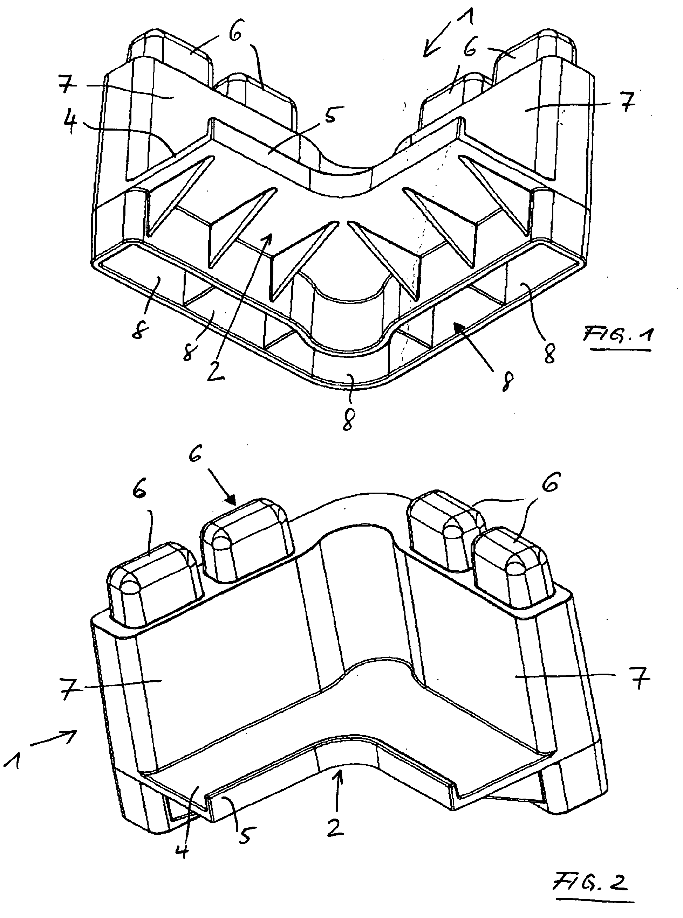

Das in den Figuren 1 bis 4 gezeigte jeweilige Formteil-Glied 1 ist beispielsweise als Kunststoff-Spritzgussteil ausgebildet und weist eine rechtwinklige Form auf. Das Formteil-Glied 1 ist innenseitig mit einem Last aufnehmenden Tragprofil 2 als Auflagevorrichtung für das Photovoltaik-Modul 3 versehen. Das Tragprofil 2 ist im wesentlichen durch einen horizontalen Plattenabschnitt 4 sowie im Bereich des inneren Endes des Plattenabschnitts 4 durch einen vertikalen, nach oben gerichteten Randabschnitt 5 gebildet. Oberseitig weist das Formteil-Glied 1 vier Zapfen 6 auf, wobei jedem Schenkelabschnitt 7 des rechtwinkligen Formteil-Gliedes 1 zwei Zapfen 6 zugeordnet sind. Unterseitig ist das Formteil-Glied 1 mit mehreren nach unten offenen Hohlräumen 8 versehen, wobei die vier Hohlräume 8, die den Schenkelabschnitten 7 zugeordnet sind, der Aufnahme der vier Zapfen 6 des darunter befindlichen Formteil-Gliedes dienen.

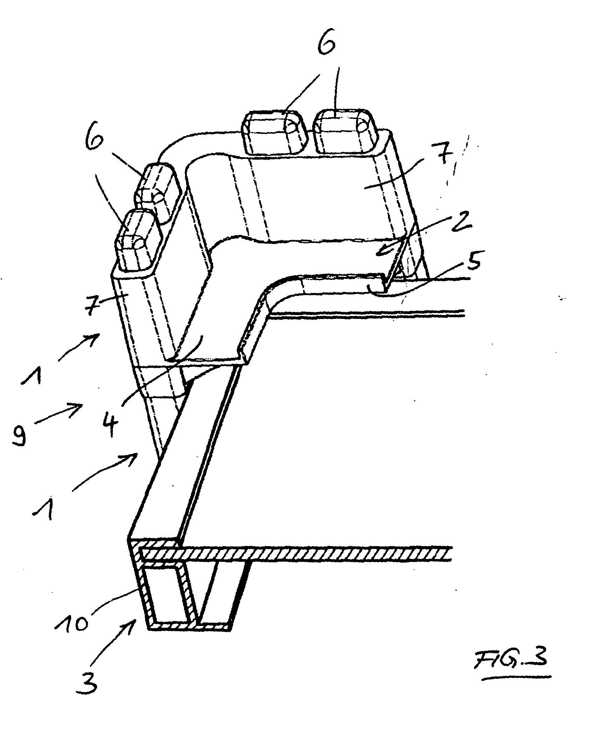

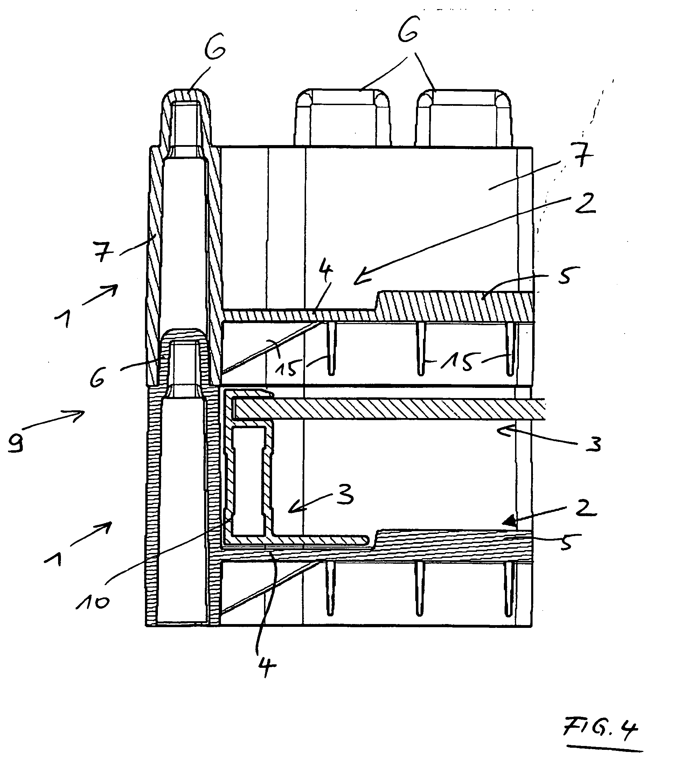

Aus einer Vielzahl von Formteil-Gliedern 1 lässt sich so eine hochbelastbare Tragsäule 9 bilden, die in den Figuren 3 und 4 nur bezüglich zweier aufeinander gesteckter Formteil-Glieder 1 veranschaulicht ist. Die verschiebungssichere Verbindung jedes Formteil-Gliedes 1 mit den benachbarten Formteil-Glied 1 wird durch die Steckmechanik erzielt, die bei diesem Ausführungsbeispiel durch die Zapfen-Hohlraum-Konstruktion verwirklicht ist. Das modulare Stecksystem bildet vier lastabtragende Eck-Tragsäulen 9, wobei in die Tragprofile 2 der Tragsäulen 9 das PV-Modul 3 mit seinen vier Ecken passgenau eingefügt wird.

Die Ausgestaltung des innenseitigen Tragprofils 2 des Formteil-Gliedes 1 ist davon abhängig, ob das erfindungsgemäße modulare Stecksystem der Transportsicherung von gerahmten oder ungerahmten PV-Modulen 3 dienen soll.

Die Figuren 3 und 4 zeigen das Beispiel eines Formteil-Gliedes 1, das die Ecke eines gerahmten PV-Moduls 3 aufnehmen soll. Das innenseitige Tragprofil 2 verfügt über die horizontale Auflagefläche 4, deren Breite auf die Breite des rückseitigen Rahmenprofils 10 im Eckbereich des aufzulegenden PV-Moduls 3 abgestimmt ist. Der vertikale Randabschnitt 5 hat die Funktion einer vertikalen Spreizsicherung und gewährleistet den passgenauen Sitz der Rahmenecke mit nur minimalem Spiel. Der vertikale Abstand zwischen dem horizontalen Tragprofil 2 eines Formteil-Gliedes 1 und dem Tragprofil 2 des benachbarten Formteil-Gliedes 1 ist durch die Dicke des gerahmten PV-Moduls 3 plus der durchschnittlichen Dicke einer menschlichen Fingerspitze definiert. Dadurch ist ein müheloses Abheben der einzelnen PV-Module 3 vom Stapel gewährleistet.

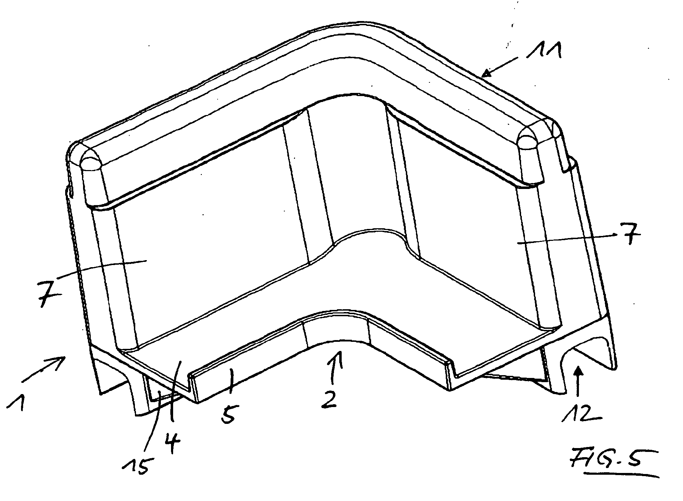

Figur 5 veranschaulicht eine andere sinnvolle Ausgestaltung des erfindungsgemäßen, modularen Stecksystems, bei der die grundsätzliche Gestaltung des Formteil-Gliedes 1 der dem Formteil-Glied 1 gemäß der Ausführungsform nach den Figuren 1 bis 4 entspricht. Allerdings ist bei der Ausführungsform nach der Figur 5 statt der vier oberen Zapfen 6 eine durchgehende, somit rechtwinklig abgewinkelte Feder 11 und statt der unteren Hohlräume 8 eine durchgehende, abgewinkelte Nut 12 vorgesehen. Beim Aufeinanderstecken der Formteil-Glieder 1 greift die Nut 12 des oberen Formteil-Gliedes 1 in die Feder 11 des unteren Formteil-Gliedes 1 ein.

Sowohl bei Zapfen-Hohlraum-Steckverbindungen wie auch bei Nut-Feder Verbindungen ist es von Vorteil für die Handhabung des Systems, wenn Zapfen oder Feder leicht konisch geformt und an den Kanten abgerundet oder abgeschrägt sind.

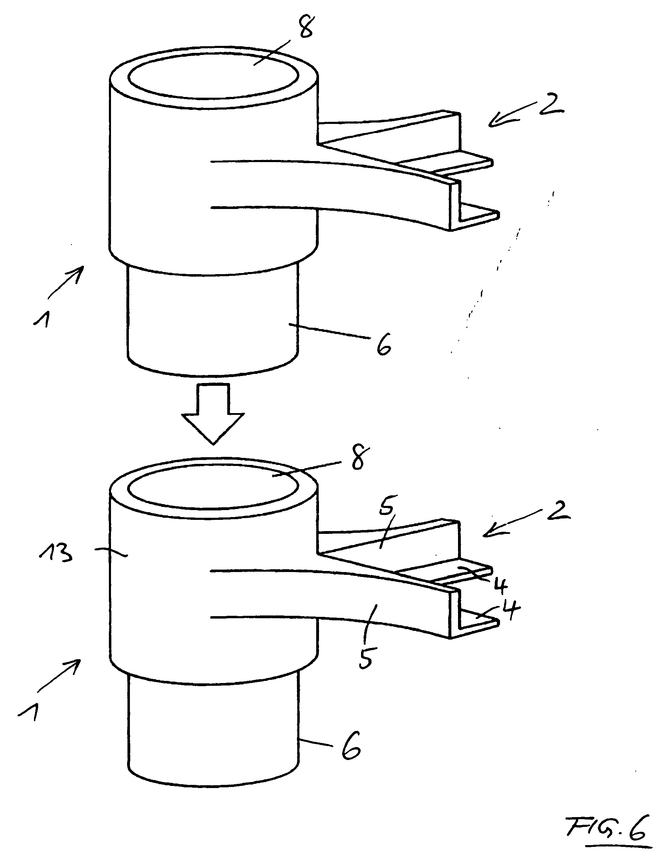

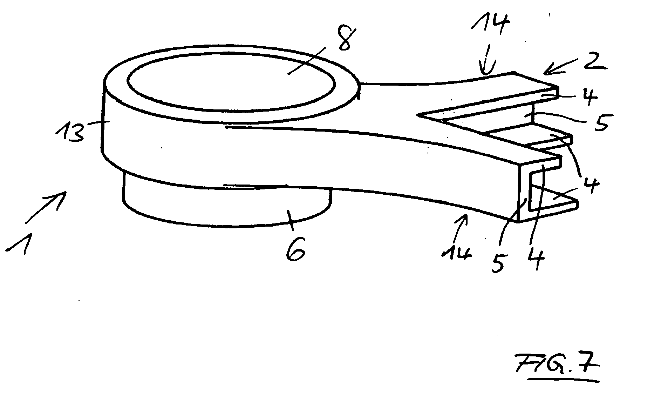

Die in den bisher erörterten Figuren abgebildete rechtwinklig winkelförmige Form der Formteil-Glieder 1 stellt eine sinnvolle, aber nicht die einzig mögliche Gliederform des erfindungsgemäßen modularen Stecksystems zur Transportsicherung von gestapelten PV-Modulen dar. Eine weitere vorteilhafte Gestaltung der Formteil-Glieder ist in den Figuren 6 und 7 veranschaulicht.

Figur 6 zeigt zwei Formteil-Glieder 1, die zusammengesteckt eine runde Tragsäule bilden. Die Steckverbindung erfolgt hier jeweils über nur einen unteren Zapfen 6 und einen oberen Hohlraum 8. Neben einer winkelförmigen oder runden Formgebung der Tragsäule sind ebenso dreieckige, viereckige oder mehreckige Formen möglich.

Bei der Ausführungsform nach der Figur 6 ist das Formteil-Glied 1 gleichfalls als Kunststoff-Spritzgussteil ausgebildet. Das Tragprofil 2 weist den unteren Plattenabschnitt 4 sowie den äußeren, die Anbindung zum Hohlzylinderabschnitt 13 des Formteil-Gliedes 1 darstellenden vertikalen Randabschnitt 5 auf. Der Au-ßendurchmesser des Zapfens 6 ist auf den Innendurchmesser des Hohlzylinderabschnitts 13 abgestimmt, so dass der Zapfen 6 mit geringem Spiel in den Hohlraum 8 des benachbarten Formteil-Gliedes 1 eingesteckt werden kann.

Das Tragprofil 2 gemäß dem Ausführungsbeispiel nach der Figur 6 kann durchaus auch die Ecke eines ungerahmten PV-Moduls 3 aufnehmen.

Figur 7 zeigt das Beispiel eines Formteil-Gliedes 1, das die Ecke eines ungerahmten PV-Moduls aufnehmen soll. Das innenseitige Tragprofil 2 ist hier in Form von zwei parallel über Eck verlaufenden horizontalen Stegen 14 ausgebildet. Die Ecke des ungerahmten PV-Moduls wird zwischen diese beiden Stege 14 eingefügt.

Für eine sichere Lastübertragung vom horizontalen Tragprofil 2 auf die Tragsäule sollte das Tragprofil im Übergangsbereich von der Horizontalen in die Vertikale dickwandiger gestaltet sein als im horizontalen Lastaufnahmebereich. Dies ist insbesondere zu der Ausführungsform nach den Figuren 1 bis 4 dargestellt. Sie zeigt eine material- und gewichtssparende Gestaltung. Hier ist das Tragprofil 2 relativ dünnwandige ausgebildet, wird jedoch unterseitig mit vertikalen Stützrippen 15 abgestützt.

Auch die Formteil-Glieder selbst können materialsparend gestaltet sein, indem sie - zusätzlich zu den für die Aufnahme von Zapfen erforderlichen offenen Hohlräumen - weitere vertikale, nach unten offene Hohlkammern enthalten.

Weitere optionale Ausgestaltungsmerkmale des erfindungsgemäßen modularen Stecksystems sind:
- dass - vor allem bei winkelförmigen Tragsäulen - alle vertikalen Kanten der Formteil-Glieder abgerundet oder abgeschrägt sind, um sie bei Beund Entladevorgängen unter sehr beengten Bedingungen gegen "Anecken" zu schützen.
- und dass die Formteil-Glieder oberseitig mit einer Nut oder Kantenfase ausgestattet sind, die der Aufnahme bzw. Führung von Spannbändern dient.

Ein Bestandteil der Erfindung ist des weiteren die Option, das lastabtragende Säulen-System aus Formteil-Gliedern durch Basis-Glieder zu ergänzen, insbesondere die 4 Säulen durch 4 Basis-Glieder zu ergänzen. Ein solches Basisglied dient der Justierung einer Säule bzw. ihres untersten Steckgliedes auf der Trägerpalette.
Das Basisglied besteht aus einer kleinformatigen Platte, die oberseitig mit einem oder mehreren Zapfen oder einer Feder und unterseitig mit entsprechenden nach unten offenen Hohlräumen bzw. einer Nut ausgestattet ist. Die Platte des Basisgliedes ist gelocht, sodass sie auf die Trägerpalette aufgenagelt oder aufgeschraubt werden kann.

Durch diese Ausgestaltung ist das Basisglied auch zum Aufstecken auf das oberste Formteilglied geeignet, um - bei Übereinanderstapelung von zwei beladenen Paletten - das passgenaue Aufsetzen der zweiten Palette zu erleichtern.

Alle Teile des erfindungsgemäßen modularen Stecksystems sind vorteilhaft im Spritzguss-Verfahren herstellbar und bestehen aus ungefülltem oder mineralisch gefülltem thermoplastischem Kunststoff, ersatzweise aus Leichtmetall.

### Beispiele

für die Anwendung des erfindungsgemäßen modularen Stecksystems und dessen Vorteile:

### BEISPIEL 1

Aufgabe: 150 gerahmte Standard-PV-Module mit jeweils 1 qm Fläche sollen für den Versand vom Modulhersteller zum Kunden transportsicher verpackt werden.

### A: Lösung der Aufgabe nach der herkömmlichem Verpackungsmethode Arbeitsschritte:

1. Jedes der 150 PV-Module wird einzeln mit Wellpappekarton und Klebebändern verpackt.
2. Maximal 15 einzeln verpackte Module werden auf einer Holzpalette bündig gestapelt ( keine Normpalette, sondern eine branchenübliche Spezialpalette, die auf die Flächenmaße des Produktes abgestimmt ist).
3. Die beladene Palette wird mit Spannbändern gesichert. Die Höhe jedes der 10 Stapel auf Palette beträgt ca. 90 cm.

### Bilanz:

Die Arbeitszeit für die 3 Arbeitsschritte, bezogen auf 150 PV-Module, beträgt 5 Arbeitskraft-Stunden.
Der Verbrauch an Verpackungsmaterial (ohne Klebe- und Spannband) beträgt 10 Paletten und ca. 330 qm Kartonage.

### B: Lösung der Aufgabe unter Verwendung des erfindungsgemäßen modularen Stecksystems

### Arbeitsschritte:

1. In den 4 Eckbereichen der Spezialpalette werden 4 erfindungsgemäße Formteil-Glieder aufgesetzt. Die Formteil-Glieder verfügen innenseitig über ein Tragprofil zum passgenauen Einfügen des rückseitigen Rahmenprofils im Eckbereich des gerahmten PV-Moduls. (vgl. Fig. 1-4) Ein erstes (unverpacktes) PV-Modul wird in die Formteil-Glieder eingehängt.
   Sodann werden weitere 4 Formteil-Glieder jeweils auf die unteren Formteil-Glieder aufgesteckt.
   Sodann wird das nächste (unverpackte) PV-Modul eingehängt. Weitere 4 Formteilglieder werden auf die darunter befindlichen Formteilglieder aufgesteckt.
   Das nächste (unverpackte) PV-Modul wird eingehängt ...etc...etc.
   Der simple Vorgang wiederholt sich solange, bis pro Palette 25 PV-Module in das aus den Formteilgliedern gebildete 4-Säulen-System eingehängt sind und die Stapelhöhe (incl. Palette) ca. 160 cm beträgt.
2. Jeder der so gebildeten 6 palettierten Stapel wird kartoniert und mit Spannband gesichert.

### Bilanz:

Die Arbeitszeit für die Arbeitsschritte, bezogen auf 150 PV-Module, beträgt 1,25 Arbeitskraft-Stunden.
Der Verbrauch an Verpackungsmaterial (ohne Spannband) beträgt 6 Paletten und ca. 45 qm Kartonage. Hinzu kommen 600 erfindungsgemässe Formteil-Glieder, die im Pfandsystem rückgeholt und ca. 50 mal wiederverwendet werden.

### C: Bilanzvergleich zwischen A und B

Die Verwendung des erfindungsgemäßen modularen Stecksystems erspart gegenüber der herkömmlichen Transportverpackung 3,75 Arbeitskraft-Stunden Arbeitszeit, 4 Holzpaletten und ca. 280 qm Kartonage.

Dem steht ein zusätzlicher Materialbedarf von 600 erfindungsgemäßen wiederverwendbaren Formteilgliedern gegenüber. Bei 50-maligem Umlauf entspricht dies einem Materialverbrauch von 12 Formteilgliedern.

### BEISPIEL 2:

Aufgabe: Ungerahmte Standard-PV-Module sollen für den Versand vom Modulhersteller zum Kunden transportsicher verpackt werden.

Das herkömmliche Verpackungsverfahren entspricht hier im wesentlichen der Version A im Beispiel 1.

Bei Anwendung des erfindungsgemäßen modularen Stecksystems wird die Aufgabe gelöst, indem Formteilglieder eingesetzt werden, deren Tragprofil in Form von 2 parallel übereck verlaufenden horizontalen Stegen ausgebildet ist (vgl. Fig. 7).
In diesem Falle werden 4 derartige Formteilglieder zunächst jeweils über die 4 Ecken des ungerahmten PV-Moduls gesteckt und sodann mitsamt dem PV-Modul auf die Palette gesetzt bzw. in der Folge auf den nach oben wachsenden 4-Säulen-Stapel aufgesteckt.

Die Vorteile hinsichtlich Arbeitszeit- und Verpackungsmaterialersparnis entsprechen im wesentlichen dem Beispiel 1.

### BEISPIEL 3

Aufgabe: Die Ladehöhe eines LKW soll durch Übereinanderstapelung von jeweils 2 palettierten Stapelpackungen ausgenutzt werden.

Bei Anwendung der (im Beispiel 1 beschriebenen) herkömmlichen Verpackungsmethode ist diese Aufgabe nicht lösbar, denn die auf der unteren Palette liegenden, einzeln verpackten PV-Module würden durch das Auflegen eines zweiten Palettenstapels unzulässig belastet.

Das Risiko, dass insbesondere die unten liegenden PV-Module unter den beim Transport auftretenden dynamischen Belastungen beschädigt werden, wäre sehr hoch.
Demgegenüber erlaubt die Verwendung des erfindungsgemäßen modularen Stecksystems das Übereinanderstapeln von zwei (z.B. jeweils 1 m hohen) palettierten Stapeln, da die aus Formteilgliedern gebildete 4-Säulen-Konstruktion für entsprechend hohe Belastungen ausgelegt ist.

### BEISPIEL 4

Aufgabe: 20 PV-Module mit jeweils 1 qm Fläche sollen am Montage-Ort von der Palette genommen bzw. ausgepackt werden.

### A: Lösung der Aufgabe nach der herkömmlichem Verpackungsmethode

Die PV-Module werden - einzeln kartoniert - auf 2 Paletten angeliefert.
Die Spannbänder werden entfernt, jedes Modul wird einzeln ausgepackt. 2 Paletten und ca. 45 qm Kartonage fallen zur Entsorgung an.

### B: Lösung der Aufgabe unter Verwendung des erfindungsgemäßen modularen Stecksystems

Die PV-Module werden auf einer - in ihrer Gesamtheit kartonierten - Paletteneinheit angeliefert. Die Spannbänder und der Karton werden entfernt. Die unverpackten PV-Module werden einzeln abgehoben.
Die Formteilglieder der Tragsäulen werden successiv "abgepflückt" und landen in mitgelieferten kleinen Kartons für die Rückholung zwecks Wiederverwendung.
1 Palette und ca. 6 qm Kartonage fallen zur Entsorgung an.

## Patentansprüche

1. Modulares Stecksystem zur sicheren Lagerung von horizontal gestapelten Photovoltaik-Modulen (3), wobei das System ausschließlich aus einzelnen vertikal angeordneten, lastabtragenden Säulen (9) gebildet ist, die jeweils aus Formteil-Gliedern (1) bestehen, die übereinander angeordnet und ineinander gesteckt die jeweilige Säule (9) bilden, wobei jedes dieser Formteil-Glieder (1), auf der Seite, die zu dem zu tragenden Photovoltaik-Modul (3) hin gerichtet ist, mit einem lastaufnehmenden Tragprofil (2) als Auflagevorrichtung für das Photovoltaik-Modul (3), oberseitig bzw. unterseitig mit einem oder mehreren Zapfen (6) oder einer Feder (11) und unterseitig bzw. oberseitig mit einem oder mehreren offenen Hohlräumen (8) zur passgenauen Aufnahme der/des Zapfen(s) (6) oder mit einer Nut (12) zur Aufnahme der Feder (11) ausgestattet ist.

2. System nach Anspruch 1, wobei es vier lastabtragende Säulen (9), insbesondere vier lastabtragende Ecksäulen (9) bildet.

3. System nach Anspruch 1 oder 2, wobei das Photovoltaik-Modul (3) rechteckig ausgebildet ist.

4. Stecksystem nach einem der Ansprüche 1 bis 3, wobei die lastabtragenden Säulen (9) runden, eckigen oder rechtwinkligen Querschnitt aufweisen.

5. Stecksystem nach einem der Ansprüche 1 bis 4, wobei es zur Transportsicherung von gerahmten Photovoltaik-Modulen (3) dient und das Tragprofil (2) jedes Formteil-Gliedes (1) auf das Rahmenprofil im Eckbereich des Photovoltaik-Moduls (3) passgenau abgestimmt ist.

6. Stecksystem nach einem der Ansprüche 1 bis 4, wobei es zur Transportsicherung von ungerahmten Photovoltaik-Modulen (3) dient und das Tragprofil (2) jedes Formteil-Gliedes (1) aus zwei parallelen horizontalen Stegen (14) besteht, zwischen die jeweils eine Ecke des ungerahmten Photovoltaik-Moduls (3) passgenau einfügbar ist.

7. Stecksystem nach einem der Ansprüche 1 bis 6, wobei das Tragprofil (2) unterseitig mit vertikalen Stützrippen (15) ausgestaltet ist.

8. Stecksystem nach einem der Ansprüche 1 bis 7, wobei die Zapfen (6) oder Federn (11) der Formteil-Glieder (1) an deren horizontalen und vertikalen Kanten abgerundet oder abgeschrägt sind.

9. Stecksystem nach einem der Ansprüche 1 bis 8, wobei die Zapfen (6) oder Federn (11) der Formteil-Glieder (1) leicht konisch geformt sind.

10. Stecksystem nach einem der Ansprüche 1 bis 9, wobei alle vertikalen Kanten der Formteil-Glieder (1) abgerundet oder abgeschrägt sind.

11. Stecksystem nach einem der Ansprüche 1 bis 10, wobei die Formteil-Glieder (1) massiv gestaltet sind oder - zusätzlich zu den für die Aufnahme der Zapfen (6) erforderlichen offenen Hohlräume (8) - vertikale, zum benachbarten Formteil-Glied (1) offene Hohlkammern (8) enthalten.

12. Stecksystem nach einem der Ansprüche 1 bis 11, wobei der vertikale Abstand zwischen dem horizontalen Tragprofil (2) eines Formteil-Gliedes (1) und dem horizontalen Tragprofil (2) des darüber gesteckten Formteil-Gliedes (1) der Dicke eines gerahmten Photovoltaik-Moduls (3) plus der durchschnittlichen Dicke einer menschlichen Fingerspitze entspricht.

13. Stecksystem nach einem der Ansprüche 1 bis 12, wobei die Formteil-Glieder (1) oberseitig mit einer Nut oder Kantenfase zur Aufnahme von Spannbändern ausgestattet sind.

14. Stecksystem nach einem der Ansprüche 1 bis 13, wobei alle Formteil-Glieder (1) im Spritzgussverfahren hergestellt sind und aus ungefülltem oder mineralisch gefülltem thermoplastischen Kunststoff oder Leichtmetall bestehen.

## Claims

1. Modular assembling system for the safe storage of horizontally stacked photovoltaic modules (3), in which the system is made exclusively of individual, load transferring columns (9), which are arranged vertically, each consisting of moulded elements (1), which are arranged on top of each other and assembled in each other to form the relevant columns (9), in which on the side facing the photovoltaic module (3) to be carried, each of these moulded elements (1) is fitted with a load bearing carrier profile (2) as a bearing device for the photovoltaic module (3), on the top or on the bottom with one or several plugs (6) or a spring (11) and on the bottom or on the top with one or several open cavities (8) for accommodating the plug(s) (6) so they fit precisely or with a groove for (12) for accommodating the spring (11).

2. System according to claim 1, in which it forms four load transferring columns (9), particularly four load transferring corner columns (9).

3. System according to claim 1 or 2, in which the photovoltaic module (3) is made rectangular.

4. Assembly system according to one of claims 1 to 3, in which the load transferring columns (9) have a round, square or rectangular cross section.

5. Assembly system according to one of clams 1 to 4, in which it is used to secure the transport of framed photovoltaic modules (3) and the carrier profile (2) of each moulded element (1) is made to fit precisely on the frame profile in the corner area of the photovoltaic module (3).

6. Assembly system according to one of claims 1 to 4, in which it is used to secure the transport of unframed photovoltaic modules (3) and the carrier profile (2) of each moulded element (1) consists of two parallel horizontal brackets (14), between which a corner of the unframed photovoltaic module (3) can be inserted to fit precisely.

7. Assembly system according to one of claims 1 to 6, in which the carrier profile (2) is made with vertical stiffening ribs (15) on the bottom.

8. Assembly system according to claims 1 to 7, in which the plugs (6) or springs (11) of the moulded elements (1) are rounded or bevelled on their horizontal and vertical edges.

9. Assembly system according to one of claims 1 to 8, in which the plugs (6) or springs (11) of the moulded elements (1) are made slightly conical.

10. Assembly system according to one of claims 1 to 9, in which all the vertical edges of the moulded elements (1) are rounded or bevelled.

11. Assembly system according to one of claims 1 to 10, in which the moulded elements (1) are made solid or - in addition to the open cavities (8) needed to accommodate the plugs (6) - contain vertical hollow spaces (8), which are open to the adjacent moulded element (1).

12. Assembly system according to one of claims 1 to 11, in which the vertical distance between the horizontal carrier profile (2) of a moulded element (1) and the horizontal carrier profile (2) of the moulded element (1) assembled on it corresponds to the thickness of a framed photovoltaic module (3) plus the average thickness of a human finger.

13. Assembly system according to one of claims 1 to 12, in which the moulded elements (1) are fitted with a groove or edge chamfer on the top to accommodate tightening straps.

14. Assembly system according to one of claims 1 to 13, in which all the moulded elements (1) are made using the injection moulding process and consist of unfilled or mineral filled thermoplastic or light metal.

## Revendications

1. Système d'emboîtement modulaire pour l'entreposage fiable de modules photovoltaïques (3) empilés à l'horizontale, le système étant formé exclusivement par des montants individuels (9) du type diminuant la charge, disposés à la verticale, qui sont constitués respectivement par des éléments moulés (1) qui, en étant superposés et insérés les uns dans les autres forment le montant respectif (9), chacun de ces éléments moulés (1), du côté qui est orienté en direction du module photovoltaïque (3) à supporter, est équipé d'un profilé de support absorbant la charge (2) à titre de dispositif d'appui pour le module photovoltaïque (3), en haut, respectivement en bas d'un ou de plusieurs tourillons (6) ou d'un ressort (11), et en bas, respectivement en haut, deux ou de plusieurs espaces creux ouverts (8) pour la réception en ajustage serré du/des tourillon(s) (6) ou d'une rainure (12) pour la réception du ressort (11).

2. Système selon la revendication 1, qui forme quatre montants (9) diminuant la charge, en particulier quatre montants de coins (9) diminuant la charge.

3. Système selon la revendication 1 ou 2, dans lequel le module photovoltaïque (3) est réalisé avec une configuration rectangulaire.

4. Système d'emboîtement selon l'une quelconque des revendications 1 à 3, dans lequel les montants (9) diminuant la charge présentent une section transversale ronde, anguleuse ou rectangulaire.

5. Système d'emboîtement selon l'une quelconque des revendications 1 à 4, qui trouve une utilisation pour la fixation, lors du transport, de modules photovoltaïques encadrés (3), dans lequel le profilé de support (2) de chaque élément moulé (1) est précisément adapté au profilé d'encadrement dans la zone des coins du module photovoltaïque (3) .

6. Système d'emboîtement selon l'une quelconque des revendications 1 à 4, qui trouve une utilisation pour la fixation, lors du transport, de modules photovoltaïques non encadrés (3), dans lequel le profilé de support (2) de chaque élément moulé (1) est constitué par deux nervures horizontales parallèles (14) entre lesquelles vient s'insérer en ajustage serré un coin respectif du module photovoltaïque non encadré (3).

7. Système d'emboîtement selon l'une quelconque des revendications 1 à 6, dans lequel le profilé de support (2) est équipé, en bas, de nervures d'appui verticales (15).

8. Système d'emboîtement selon l'une quelconque des revendications 1 à 7, dans lequel les tourillons (6) ou les ressorts (11) des éléments moulés (1) sont arrondis ou chanfreinés à leurs arêtes horizontales et à leurs arêtes verticales.

9. Système d'emboîtement selon l'une quelconque des revendications 1 à 8, dans lequel les tourillons (6) ou les ressorts (11) des éléments moulés (1) présentent une configuration légèrement chronique.

10. Système d'emboîtement selon l'une quelconque des revendications 1 à 9, dans lequel toutes les arêtes verticales des éléments moulés (1) sont arrondies ou chanfreinées.

11. Système d'emboîtement selon l'une quelconque des revendications 1 à 10, dans lequel les éléments moulés (1) sont réalisés pour être massifs ou bien contiennent - en plus des espaces creux ouverts (8) requis pour la réception des tourillons (6) - des chambres creuses verticales (8) ouvertes en direction de l'élément moulé voisin (1).

12. Système d'emboîtement selon l'une quelconque des revendications 1 à 11, dans lequel l'écartement vertical entre le profilé de support horizontal (2) d'un élément moulé (1) et le profilé de support horizontal (2) de l'élément moulé (1) emboîté par-dessus, correspond à l'épaisseur d'un module photovoltaïque encadré (3) plus l'épaisseur moyenne d'un bout de doigt humain.

13. Système d'emboîtement selon l'une quelconque des revendications 1 à 12, dans lequel les éléments moulés (1) sont équipés, en haut, d'une rainure ou d'un chanfrein pour la réception de rubans de serrage.

14. Système d'emboîtement selon l'une quelconque des revendications 1 à 13, dans lequel tous les éléments moulés (1) sont réalisés dans un procédé de moulage par injection et sont constitués par un métal léger ou par une matière synthétique thermoplastique exempte de matières de charge au contenant des matières de charge minérales.
